# EUROPÄISCHE PATENTANMELDUNG

(11) **EP 4 071 951 A1**
(43) Veröffentlichungstag der Anmeldung: **12.10.2022**
(21) Anmeldenummer: 22160352.5
(22) Anmeldetag: 04.03.2022
(51) Int. Cl.: H02H 3/33, B60L 53/68, G01R 31/40, H02H 3/04

(54) **VERSORGUNGSSTATION UND BETRIEBSVERFAHREN HIERFÜR**

(30) Priorität: 11.03.2021 DE 102021105956
(71) Anmelder: Compleo Charging Solutions AG, 44309 Dortmund (DE)
(72) Erfinder: Checrallah, Kachouh, 44227 Dortmund (DE)
(74) Vertreter: Wickord, Wiro

(57) **Zusammenfassung**

Die Erfindung betrifft ein Betriebsverfahren für eine Versorgungsstation mit einem Fehlerstromschutzschaltelement (1), wobei zunächst ein Auslösemodul (3) einer dem Fehlerstromschutzschaltelement zugeordneten Testeinrichtung in einer Unterbrechungsschaltstellung, in der eine das Auslösemodul vorsehende Strom-Bypass-Leitung (2) geöffnet ist, die unter Umgehung des Fehlerstromschutzschaltelements von einem Nullleiter zu einem ausgewählten Phasenleiter oder dem PE-Leiter geführt ist, und das Fehlerstromschutzschaltelement in einer Überwachungsschaltstellung vorgesehen werden, in der der Differenzstrom-Fehlerfall erkannt wird, und eine Zeitintervall-Ermittlung gestartet wird. Dann wird zeitgesteuert nach Ablauf des Zeitintervalls eine Funktionsselbsttestroutine für das Fehlerstromschutzschaltelement durchgeführt, wobei ein Auslösesignal (6) von einer Steuereinheit (5) an das Auslösemodul gesendet wird, wobei das Auslösemodul das Auslösesignal empfängt und von der Unterbrechungsschaltstellung in eine Verbindungsschaltstellung verbracht wird, in der die Strom-Bypass-Leitung den Nullleiter unter Umgehung des Fehlerstromschutzschaltelements mit dem ausgewählten Phasenleiter oder dem PE-Leiter elektrisch leitend verbindet und über den Strom-Bypass-Leiter ein Bypass-Strom fließt, der betragsmäßig von einem Stromvorgabemodul (4) bestimmt ist und der oberhalb eines Mindestauslösedifferenzstroms des Fehlerstromschutzschaltelements liegt, wobei dann eine Schaltstellung des Fehlerstromschutzschaltelements bestimmt und ein Ergebnis der Funktionsselbsttestroutine dokumentiert wird, indem zur Dokumentation eine Ausführungszeitinformation einerseits und die Schaltstellung des Fehlerstromschutzschaltelements oder ein hierzu korrespondierender Zustandswert anderseits in einem der Steuereinheit zugeordneten Datenspeicher gespeichert werden, und wobei die Versorgungsstation außer Betrieb genommen wird, sofern das Fehlerstromschutzschaltelement nicht auslöst und in der Überwachungsschaltstellung vorgesehen ist. Ferner betrifft die Erfindung eine zur Durchführung des Betriebsverfahrens eingerichtete Versorgungsstation.

Abb. 1

## Beschreibung

Die Erfindung betrifft ein Betriebsverfahren für eine Versorgungsstation mit einem Fehlerstromschutzschaltelement. Ferner betrifft die Erfindung eine zur Durchführung des Betriebsverfahrens eingerichtete Versorgungsstation.

Die Funktionsfähigkeit des Fehlerstromschutzschaltelements einer Versorgungsstation wird heute in regelmäßigen oder unregelmäßigen Zeitintervallen manuell getestet. Zu diesem Zweck wird von einem Benutzer oder einem Wartungsdienstmitarbeiter eine an dem Fehlerstromschutzschaltelement vorgesehene Prüftaste betätigt und die Funktion des Fehlerstromschutzschaltelements überprüft. Sofern die Prüfung durch den Benutzer erfolgt, ist das Fehlerstromschutzschaltelement üblicherweise zugänglich in einem Gehäuse der Versorgungsstation und getrennt von anderen elektrischen Funktionskomponenten der Versorgungsstation angeordnet. Beispielsweise sieht das Gehäuse der Versorgungsstation eine Klappe vor, hinter der das Fehlerstromschutzschaltelement angeordnet ist. Die weiteren elektrischen Funktionskomponenten der Versorgungsstation sind unzugänglich und vor missbräuchlicher oder unbeabsichtigter Berührung geschützt angeordnet. Erfolgt die Überprüfung im Rahmen der Installation, Wartung oder Instandsetzung durch geschultes Fachpersonal, kann das Fehlerstromschutzschaltelement gemeinsam mit den anderen elektrischen Funktionskomponenten manipulationsgeschützt in dem verschließbaren Gehäuse der Versorgungsstation angeordnet sein.

Nach der Durchführung des Funktionstests wird das Fehlerstromschutzschaltelement, sofern es erfolgreich getestet wurde und ausgelöst hat, manuell aus einer Fehlerschaltstellung, in der eine elektrisch leitende Verbindung zwischen einem dem Anschluss eines elektrisch betreibbaren Fahrzeugs oder eines anderen nicht stationären Verbrauchers an die Versorgungsstation dienenden Anschlussmittel und einem Versorgungsnetz unterbrochen ist, in eine Überwachungsschaltstellung zurückverbracht, in der ein Differenzstrom zwischen wenigstens einem Phasenleiter und/oder einem Nullleiter der elektrisch leitenden Verbindung von Anschlussmittel und Versorgungsnetz überwacht wird.

In der Praxis hat sich hierbei gezeigt, dass die Funktionsprüfung des Fehlerstromschutzschaltelements in manchen Fällen nicht ausreichend häufig durchgeführt wird und ein Funktionsausfall nicht beziehungsweise nicht rechtzeitig erkannt wird.

Aufgabe der vorliegenden Erfindung ist es demzufolge, ein Betriebsverfahren für eine Versorgungsstation mit einer Funktionsselbsttestroutine für das Fehlerstromschutzschaltelement sowie eine zur Durchführung des Betriebsverfahrens eingerichtete Versorgungsstation anzugeben.

Zur Lösung der Aufgabe weist die Erfindung die Merkmale der Patentansprüche 1 und 14 auf. Demzufolge sieht das Betriebsverfahren für eine Versorgungsstation mit einem Fehlerstromschutzschaltelement vor, dass zunächst ein Auslösemodul einer dem Fehlerstromschutzschaltelement zugeordneten Testeinrichtung in einer Unterbrechungsschaltstellung vorgesehen wird, in der eine das Auslösemodul vorsehende Strom-Bypass-Leitung geöffnet ist, die unter Umgehung des Fehlerstromschutzschaltelements von einem Nullleiter einerseits zu einem ausgewählten Phasenleiter oder dem PE-Leiter anderseits geführt ist, dass das Fehlerstromschutzschaltelement in einer Überwachungsschaltstellung vorgesehen wird, in der der Differenzstrom-Fehlerfall erkannt wird, und dass eine Zeitintervall-Ermittlung gestartet wird. Dann wird zeitgesteuert nach Ablauf des Zeitintervalls eine Funktionsselbsttestroutine für das Fehlerstromschutzschaltelement durchgeführt, wobei ein Auslösesignal von einer Steuereinheit der Versorgungsstation an das Auslösemodul gesendet wird, wobei das Auslösemodul das Auslösesignal empfängt und von der Unterbrechungsschaltstellung in eine Verbindungsschaltstellung verbracht wird, in der die Strom-Bypass-Leitung den Nullleiter einerseits mit dem ausgewählten Phasenleiter oder dem PE-Leiter anderseits elektrisch leitend verbindet und über den Strom-Bypass-Leiter ein Bypass-Strom fließt, der betragsmäßig von einem Stromvorgabemodul bestimmt ist und der oberhalb eines Mindestauslösedifferenzstroms des Fehlerstromschutzschaltelements liegt, wobei dann eine Schaltstellung des Fehlerstromschutzschaltelements bestimmt und ein Ergebnis der Funktionsselbsttestroutine dokumentiert wird, indem zur Dokumentation eine Ausführungszeitinformation einerseits und die Schaltstellung des Fehlerstromschutzschaltelements oder ein hierzu korrespondierender Zustandswert anderseits in einem der Steuereinheit zugeordneten Datenspeicher gespeichert werden, und wobei die Versorgungsstation außer Betrieb genommen wird, sofern das Fehlerstromschutzschaltelement nicht auslöst und nach wie vor in der Überwachungsschaltstellung vorgesehen ist. Die Versorgungsstation sieht dabei die Steuereinheit zum Durchführen eines Ladevorgangs und/oder eines Entladevorgangs für eine Fahrzeugbatterie, ein Anschlussmittel zum leitenden Verbinden eines elektrisch betreibbaren Fahrzeugs und/oder der Fahrzeugbatterie mit der Versorgungsstation sowie Übertragungsmittel vor, wobei die Übertragungsmittel angeordnet und ausgebildet sind zur Realisierung eines uni- oder bidirektionalen Energieflusses zwischen einem Versorgungsnetz und dem Anschlussmittel und wobei die Übertragungsmittel einen Nullleiter, einen PE-Leiter und wenigstens einen Phasenleiter umfassen. Ferner sieht die Versorgungsstation ein den Übertragungsmitteln zugeordnetes Betriebsschaltmittel zum wahlweisen Herstellen und Unterbrechen der elektrisch leitenden Verbindung zwischen dem Anschlussmittel und dem Versorgungsnetz, das Fehlerstromschutzschaltelement, welches dem wenigstens einen Phasenleiter sowie dem Nullleiter zugeordnet ist zur Erkennung eines Differenzstrom-Fehlerfalls und zur Unterbrechung der elektrisch leitenden Verbindung zwischen dem Anschlussmittel und dem Versorgungsnetz im Differenzstrom-Fehlerfall, sowie die Testeinrichtung für das Fehlerstromschutzschaltelement vor. Die Testeinrichtung umfasst die Strom-Bypass-Leitung, das von der Steuereinheit ansteuerbare Auslösemodul zum wahlweisen Öffnen oder Schließen der Strom-Bypass-Leitung und das in der Strom-Bypass-Leitung angeordnete Stromvorgabemodul.

Der besondere Vorteil der Erfindung besteht darin, dass die Funktionsfähigkeit des Fehlerstromschutzschaltelements regelmäßig und automatisiert überprüft werden kann. Die Betriebssicherheit der Versorgungsstation erhöht sich hierdurch und kritische Betriebszustände, die die Gesundheit oder das Leben des Benutzers gefährden können, werden vermieden. Der Benutzer selbst und auch das mit der Installation, Wartung beziehungsweise Instandsetzung der Versorgungsstation beauftragte Fachpersonal muss nicht tätig werden und bei der Durchführung der Funktionsselbsttestroutine noch nicht einmal vor Ort sein.

Nach der Erfindung ist vorgesehen, dass die Versorgungsstation neben den üblichen Funktionskomponenten, nämlich einer Steuereinheit zum Durchführen des Ladevorgangs beziehungsweise des Entladevorgangs, einem Anschlussmittel zum elektrisch leitenden Verbinden der Fahrzeugbatterie mit der Versorgungsstation, den Übertragungsmitteln, dem Betriebsschaltmittel zum wahlweisen Herstellen und Unterbrechen der elektrisch leitenden Verbindung zwischen dem Anschlussmittel und dem Versorgungsnetz, dem Fehlerstromschutzschaltelement und einem der Steuereinheit zugeordneten Datenspeicher eine Testeinrichtung vorsieht. Die Testeinrichtung umfasst die schaltbare Strom-Bypass-Leitung, über die ein Teilstrom als Bypass-Strom abgezweigt wird. Der Bypass-Strom fließt nicht durch das Fehlerstromschutzschaltelement und das Fehlerstromschutzschaltelement erkennt daher einen Differenzstrom-Fehlerfall. Der Bypass-Strom ist dabei so bestimmt, dass er größer ist als ein für das Fehlerstromschutzschaltelement typspezifisch beziehungsweise herstellerseitig bestimmter Mindestauslösedifferenzstrom. Der Mindestauslösedifferenzstrom definiert den kleinsten Fehlerstrom, der mittels des Fehlerstromschutzschaltelements detektiert werden kann und zur Auslösung des Fehlerstromschutzschaltelements führt.

Die Erfindung ist nicht auf die Durchführung des Selbsttests beschränkt. Die Funktionsselbsttestroutine umfasst darüber hinaus einen Dokumentationsschritt. Es wird insofern eine Schaltstellung des Fehlerstromschutzschaltelements nach dem Schließen des Auslösemoduls bestimmt und das Ergebnis dokumentiert, indem einerseits eine Ausführungszeitinformation und andererseits die Schaltstellung des Fehlerstromschutzschaltelements beziehungsweise ein hierzu korrespondierender Zustandswert in den Datenspeicher der Steuereinheit geschrieben werden. Sofern das Fehlerstromschutzschaltelement nicht ausgelöst wurde und in der Überwachungsschaltstellung vorgesehen ist, erkennt die Steuereinheit die nicht ordnungsgemäße Funktion des Fehlerstromschutzschaltelements und die Versorgungsstation wird außer Betrieb genommen.

Als Ausführungszeitinformation kann im Rahmen der Dokumentation beispielsweise ein kalendarisch bestimmter Ausführungszeitpunkt der Funktionsselbsttestroutine oder eine Betriebszeitdauer seit der letzten Ausführung der Funktionsselbsttestroutine verwendet werden.

Das Zeitintervall kann ebenfalls kalendarisch und/oder über die Betriebszeitdauer ermittelt werden. Ein Vorgabewert für das Zeitintervall kann in dem Datenspeicher gespeichert und verändert werden. Auf diese Weise ist es möglich, die Ausführungshäufigkeit der Funktionsselbsttestroutine einem Kundenwunsch oder sich ändernden gesetzlichen Vorgaben anzupassen.

Die Zeitintervall-Ermittlung kann beispielsweise durch eine Zeitmessung erfolgen oder durch wiederholten, insbesondere täglichen Vergleich der aktuellen Zeit- und Datumsangabe und dem Datum der letzten Ausführung der Funktionsselbsttestroutine. Wenn seit der letzten Ausführung der Funktionsselbsttestroutine beispielsweise sechs Monate vergangen sind, wird die Funktionsselbsttestroutine gestartet.

Der Datenspeicher kann als interner Datenspeicher, das heißt als Teil der Versorgungsstation vorgesehen sein. Alternativ oder zusätzlich kann der Datenspeicher als externer Datenspeicher ortsfern angeordnet sein. Beispielsweise kann die Dokumentation zentral beim Betreiber der Versorgungsstation erfolgen. Die interne Speicherung hat den Vorteil, dass die Dokumentation bei der Installation, Wartung oder Instandsetzung der Versorgungsstation auch dann zur Verfügung steht, wenn die Versorgungsstation nicht mit dem externen Datenspeicher verbunden ist. Zum Zwecke der externen Datensicherung sieht die Versorgungsstation beispielsweise eine Übertragungseinheit vor, die leitungsgebunden oder kabellos mit einer externen Empfangseinheit kommuniziert.

Nach einer bevorzugten Ausführungsform der Erfindung wird nach jedem Neustart beziehungsweise Reset der Versorgungsstation das Auslösemodul in der Unterbrechungsschaltstellung und das Fehlerstromschutzschaltelement in der Überwachungsschaltstellung vorgesehen und es wird die Funktionsselbsttestroutine durchgeführt. Vorteilhaft kann demzufolge die Funktionsfähigkeit des Fehlerstromschutzschaltelements sowohl automatisiert zeitgesteuert als auch ereignisgesteuert geprüft werden. Insbesondere ist es möglich, die Versorgungsstation nach der Durchführung von Installations-, Wartungs- beziehungsweise Instandsetzungsarbeiten und vor der Freigabe für den Benutzer in Bezug auf die Funktionsfähigkeit des Fehlerstromschutzschaltelements zu überprüfen. Eine fehlende Funktionsfähigkeit des Fehlerstromschutzschaltelements infolge der Wartungsbeziehungsweise Installations- und/oder Instandsetzungsarbeiten wird hierdurch zuverlässig vermieden.

Nach einer Weiterbildung der Erfindung werden die in dem Datenspeicher gespeicherte Ausführungszeitinformation und/oder die in dem Datenspeicher gespeicherte Schaltstellung des Fehlerstromschutzschaltelements beziehungsweise ein hierzu korrespondierender Zustandswert zu Beginn, während oder nach Beendigung eines Lade- beziehungsweise Entladevorgangs beim Start oder Reset der Versorgungsstation oder auf eine spezielle Anforderung hin in einem der Versorgungsstation zugeordneten Display wiedergegeben. Vorteilhaft können hierdurch der Zeitpunkt und das Ergebnis der letzten Funktionsselbsttestroutine angezeigt und im Zuge einer Wartung von einem Wartungsdienstmitarbeiter überprüft werden. Das Display kann beispielsweise als Teil der Versorgungsstation vorgesehen sein. Beispielsweise kann ein mit der Versorgungsstation verbundenes Endgerät mit einem Display, beispielsweise ein Smartphone, ein Tablet, ein Notebook oder ein PC, zur Visualisierung der Dokumentation genutzt werden. In diesem Fall ist das Display des Endgeräts der Versorgungsstation als externes Display zugeordnet.

Nach einer Weiterbildung der Erfindung kann der Datenspeicher über eine Datenschnittstelle ausgelesen werden. Vorteilhaft können hierdurch Informationen zu den Ergebnissen der Funktionsselbsttestroutine von einer externen Stelle angefordert und an diese übertragen werden.

Nach einer Weiterbildung der Erfindung liegt der Bypass-Strom bei unter 200 mA und bevorzugt im Bereich von 20 mA bis 50 mA. Vorteilhaft wird die Funktionsfähigkeit des Fehlerstromschutzschaltelements insbesondere bei einem geringen Differenzstrom geprüft, der mithin nur geringfügig oberhalb des Mindestauslösedifferenzstroms des Fehlerstromschutzschaltelements liegt. Eine Funktionsbeeinträchtigung des Fehlerstromschutzschaltelements bei kleinen Differenzströmen kann hierdurch zuverlässig erkannt und eine Gefährdung auch während der Durchführung der Funktionsselbsttestroutine vermieden werden.

Nach einer Weiterbildung der Erfindung wird der Bypass-Strom betragsmäßig durch einen Widerstand des Stromvorgabemoduls bestimmt. Hierbei wird berücksichtigt, dass der Spannungsabfall über einer von dem ausgewählten Phasenleiter zu dem Nullleiter geführten Strom-Bypass-Leitung installationsbedingt bekannt ist und sich der Bypass-Strom demzufolge über den Widerstand definieren lässt.

Sofern die Strom-Bypass-Leitung den Nullleiter und den PE-Leiter verbindet, liegt zwischen diesen Leitern in einem Normalbetriebszustand der Versorgungsstation keine Spannung an. Beide Leiter finden sich auf dem gleichen Potential. Als Teil der Testvorrichtung wird dann eine Spannungsbereitstellungseinheit vorgesehen, welche jedenfalls beim Ausführen der Funktionsselbsttestroutine eine Spannung bekannter Größe zwischen dem Nullleiter und dem PE-Leiter bereitstellt. Beispielsweise wird ein Transformator als Spannungsbereitstellungseinheit vorgesehen. Über die bekannte Spannung und den Widerstand ist dann der Bypass-Strom betragsmäßig definiert.

Nach einer Weiterbildung der Erfindung wird der Bypass-Strom über eine Konstantstromquelle des Stromvorgabemoduls bestimmt. Die Konstantstromquelle stellt unabhängig des Spannungsabfalls über der Strom-Bypass-Leitung den Bypass-Strom konstanter Größe bereit.

Nach einer Weiterbildung der Erfindung wird das Auslösesignal nach dem Ablauf des Zeitintervalls erst dann an das Auslösemodul gesendet, wenn ein im Zeitpunkt des Ablaufs des Zeitintervalls noch laufender Lade- beziehungsweise Entladevorgang beendet ist. Vorteilhaft wird hierdurch sichergestellt, dass ein laufender Lade- oder Entladevorgang nicht unterbrochen wird. Beispielsweise kann vorgesehen sein, dass die Funktionsselbsttestroutine unmittelbar nach der Beendigung des Ladebeziehungsweise Entladevorgangs gestartet wird. Dies ist unabhängig davon, ob das Fahrzeug beziehungsweise die Fahrzeugbatterie noch mit der Versorgungsstation verbunden ist. Beispielsweise kann die Funktionsselbsttestroutine nach dem Trennen des Fahrzeugs beziehungsweise der Fahrzeugbatterie von der Versorgungsstation durchgeführt werden. Beispielsweise kann zu diesem Zweck dem Anschlussmittel ein Sensor oder ein anderes geeignetes Detektormittel zugeordnet sein zur Erkennung der Anschlusssituation. Beispielsweise kann die Anschlusssituation im Rahmen einer Kommunikation zwischen der Versorgungsstation und dem Fahrzeug ermittelt werden.

Sofern im Rahmen der Funktionsselbsttestroutine erkannt wird, dass das Fehlerstromschutzschaltelement nicht ordnungsgemäß funktioniert und insbesondere nicht auslöst, wird die Versorgungsstation außer Betrieb genommen. Beispielsweise kann im Zuge der Außerbetriebnahme eine Fehlernachricht an einen Betreiber der Versorgungsstation und/oder das mit der Wartung beziehungsweise Instandsetzung beauftrage Fachpersonal gesendet werden.

Sofern demgegenüber die Funktionsfähigkeit des Fehlerstromschutzschaltelements festgestellt wird und das Fehlerstromschutzschaltelement sich nach der Durchführung der Funktionsselbsttestroutine in einer Fehlerschaltstellung befindet, in der die elektrisch leitende Verbindung zwischen dem Anschlussmittel und dem Versorgungsnetz unterbrochen ist, kann die Verbringung des Fehlerstromschutzschaltelements in die Überwachungsschaltstellung manuell und/oder automatisiert erfolgen. Bei der automatisierten Verbringung des Fehlerstromschutzschaltelements in die Überwachungsschaltstellung kann dem Fehlerstromschutzschaltelement beispielsweise eine Betätigungseinheit, insbesondere ein Aktuator zugeordnet sein. Eine manuelle Betätigung des Fehlerstromschutzschaltelements zur Rückverbringung desselben in die Überwachungsschaltstellung erfolgt bevorzugt intuitiv beziehungsweise unbemerkt beispielsweise bei dem nächsten Anschluss eines elektrisch betreibbaren Fahrzeugs an die Versorgungsstation. Hier kann beispielsweise vorgesehen sein, dass das Anschlussmittel der Versorgungsstation hinter einer Klappe oder einem anderen Verschlusselement der Versorgungsstation angeordnet ist. Wird nun die Klappe beziehungsweise das Verschlusselement vom Benutzer verschwenkt beziehungsweise betätigt, sodass das Anschlussmittel frei zugängig ist und ein Gegenanschlussmittel angesetzt werden kann, wird im Zuge der Betätigung der Klappe beziehungsweise des Verschlusselements das Fehlerstromschutzschaltelement zugleich manuell in die Überwachungsschaltstellung verbracht. Insbesondere können hierzu die Klappe beziehungsweise das Verschlusselement und das Fehlerstromschutzschaltelement mechanisch wirkverbunden sein. Beispielsweise kann zur Rückverbringung des Fehlerstromschutzschaltelements in die Überwachungsschaltstellung oder zur Betätigung des Fehlerstromschutzschaltelements und zur Rückverbringung desselben in die Überwachungsschaltstellung ein mechanisches Betätigungselement frei zugängig an einem Gehäuse der Versorgungsstation vorgesehen werden.

Als elektrisch betreibbare Fahrzeuge im Sinne der Erfindung gelten alle Automobile (PKW, LKW, Wohnmobile, Zweiräder, Busse, Transporter usw.), Schienenfahrzeuge (insbesondere Lokomotiven), Wasserfahrzeuge (Schiffe), Luftfahrzeuge sowie Anhänger (Wohnanhänger), mobile Verkaufsstände usw. Die Versorgungsstation kann insofern verwendet werden zum Bereitstellen von elektrischer Energie für Fahrzeuge mit und ohne Fahrzeugbatterie.

Aus den weiteren Unteransprüchen und der nachfolgenden Beschreibung sind weitere Vorteile, Merkmale und Einzelheiten der Erfindung zu entnehmen. Dort erwähnte Merkmale können jeweils einzeln für sich oder auch in beliebiger Kombination erfindungswesentlich sein. So kann auf die Offenbarung zu den einzelnen Erfindungsaspekten stets wechselseitig Bezug genommen werden. Die Zeichnungen dienen lediglich beispielhaft der Klarstellung der Erfindung. Sie haben keinen einschränkenden Charakter.

Es zeigen:
- Fig. 1: eine erste Ausführungsform einer Versorgungsstation mit einem Fehlerstromschutzschaltelement und einer Auslöseeinrichtung hierfür, wobei die Versorgungsstation eingerichtet ist zur Durchführung einer Funktionsselbsttestroutine für das Fehlerstromschutzschaltelement,
- Fig. 2: eine zweite Ausführungsform der Versorgungsstation, wobei ein Transformator als Teil der Auslöseeinrichtung vorgesehen ist,
- Fig. 3: eine dritte Ausführungsform der Versorgungsstation mit einer Konstantstromquelle,
- Fig. 4: eine Detaildarstellung der Konstantstromquelle der Versorgungsstation nach Fig. 3 und
- Fig. 5: eine vierte Ausführungsform der Versorgungsstation.

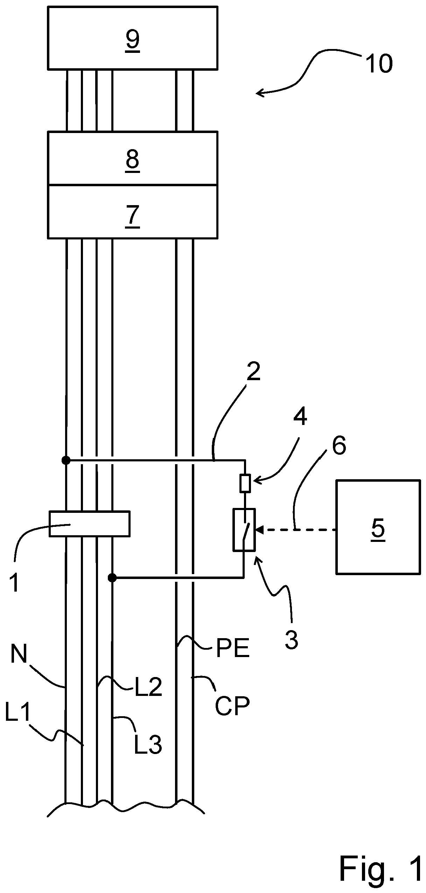

Eine erste Ausführungsform einer Versorgungsstation gemäß Figur 1 sieht ein Fehlerstromschutzschaltelement 1 und ein Anschlussmittel 7 vor, welches über Übertragungsmittel an ein Versorgungsnetz angeschlossen ist. Die Übertragungsmittel umfassen einen ersten Phasenleiter L1, einen zweiten Phasenleiter L2, einen dritten Phasenleiter L3, einen Nullleiter N, einen PE-Leiter PE sowie einen CP-Leiter CP. Die Übertragungsmittel sind angeordnet und ausgebildet zur Realisierung eines unibeziehungsweise bidirektionalen Energieflusses zwischen dem Versorgungsnetz und dem Anschlussmittel 7. Die Versorgungsstation kann insofern verwendet werden, um eine Fahrzeugbatterie 9 eines elektrisch betreibbaren Fahrzeugs, welche über ein Ladekabel 10 mit einem Gegenanschlussmittel 8 mit der Versorgungsstation verbunden ist, zu laden oder Energie aus der Fahrzeugbatterie 9 in das Versorgungsnetz zurückzuspeisen.

Die Versorgungsstation sieht überdies eine Steuereinheit 5 vor, welche der Durchführung des Lade- beziehungsweise Entladevorgangs dient und die beispielsweise ein nicht dargestelltes Betriebsschaltmittel, insbesondere ein Schütz ansteuert, mit dem wahlweise die elektrisch leitende Verbindung zwischen dem Anschlussmittel 7 und dem Versorgungsnetz hergestellt und unterbrochen wird. Zusätzlich kann die Versorgungsstation einen nicht dargestellten Energiemengenzähler und/oder Leitungssicherungen vorsehen, welche beispielsweise als Schmelzsicherung ausgeführt sind.

Zusätzlich umfasst die Versorgungsstation eine dem Fehlerstromschutzschaltelement 1 zugeordnete Testeinrichtung. Als Teil der Testeinrichtung ist eine Strom-Bypass-Leitung 2 vorgesehen, welche unter Umgehung des Fehlerstromschutzschaltelements 1 von dem Nullleiter N zu dem dritten Phasenleiter L3 geführt ist. Der Strom-Bypass-Leitung 2 sind darüber hinaus ein von der Steuereinheit 5 über eine Signalleitung 6 ansteuerbares Auslösemodul 3 zum wahlweisen Öffnen oder Schließen der Strom-Bypass-Leitung 2 und ein Widerstand 4 als Stromvorgabemodul zugeordnet.

Um nun die Funktionsfähigkeit des Fehlerstromschutzschaltelements 1 zu prüfen, wird zunächst ein definierter Ausgangsbetriebszustand herbeigeführt, indem das Auslösemodul 3 in eine Unterbrechungsstellung verbracht wird, in der die Strom-Bypass-Leitung 2 geöffnet ist, und indem das Fehlerstromschutzschaltelement 1 in eine Überwachungsschaltstellung verbracht wird, in der der Differenzstrom-Fehlerfall erkannt wird. Dann wird die Funktionsselbsttestroutine für das Fehlerstromschutzschaltelement 1 durchgeführt. Hierzu wird ein Auslösesignal von der Steuereinheit 5 an das Auslösemodul 3 gesendet. Das Auslösemodul 3 empfängt das Auslösesignal und wird von der Unterbrechungsschaltstellung in eine Verbindungschaltstellung verbracht, in der die Strom-Bypass-Leitung 2 den Nullleiter N mit dem dritten Phasenleiter L3 elektrisch leitend verbindet und ein Bypass-Strom über den Strom-Bypass-Leiter 2 fließt. Der Bypass-Strom ist betragsmäßig durch den Widerstand 4 bestimmt, da zwischen dem Nullleiter N und dem dritten Phasenleiter L3 eine bekannte Spannungsdifferenz besteht und der Bypass-Strom demzufolge über die Größe des Widerstands 4 definiert wird.

Der Bypass-Strom ist so festgelegt, dass er oberhalb eines Mindestauslösedifferenzstroms des Fehlerstromschutzschaltelements 1 liegt. Der Mindestauslösedifferenzstrom des Fehlerstromschutzschaltelements 1 ist ein typbeziehungsweise herstellerseitiger Vorgabewert. Anschließend wird eine Schaltstellung des Fehlerstromschutzschaltelements 1 bestimmt und ein Ergebnis der Funktionsselbsttestroutine dokumentiert, indem eine Ausführungszeitinformation einerseits und die Schaltstellung des Fehlerstromschutzschaltelements 1 beziehungsweise ein hierzu korrespondierender Zustandswert andererseits in einen der Steuereinheit 5 zugeordneten, nicht dargestellten Datenspeicher geschrieben werden. Sofern das Fehlerstromschutzschaltelement 1 nicht ausgelöst hat und in der Überwachungsschaltstellung vorgesehen ist, wird überdies die Versorgungsstation außer Betrieb genommen.

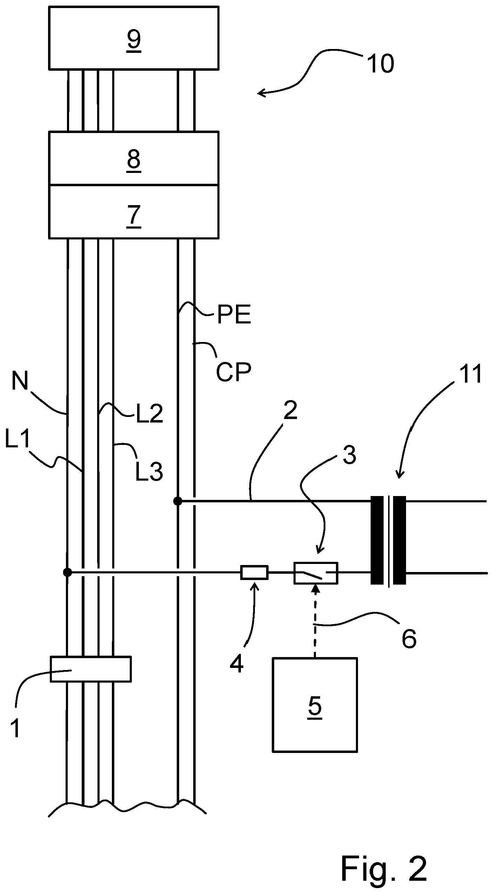

Eine zweite Ausführungsform der Versorgungsstation nach Figur 2 sieht wie gehabt das Anschlussmittel 7 sowie die Übertragungsmittel zum Verbinden des Anschlussmittels 7 mit dem Versorgungsnetz und das Fehlerstromschutzschaltelement 1 vor, welches den Phasenleitern L1, L2, L3 sowie dem Nullleiter N zugeordnet ist und eingerichtet ist zur Differenzstrom-Fehlerfallerkennung. Zudem ist wie gehabt die Steuereinheit 5 vorgesehen, die der Durchführung des Lade- beziehungsweise Entladevorgangs dient und insbesondere mit einem nicht dargestellten Betriebsschaltmittel zusammenwirkt.

Die Testeinrichtung umfasst im vorliegenden Ausführungsbeispiel neben der Strom-Bypass-Leitung 2, die von dem Nullleiter N unter Umgehung des Fehlerstromschutzschaltelements 1 zu dem PE-Leiter PE geführt ist und dazu zwischen dem Anschlusselement 7 und dem Fehlerstromschutzschaltelement 1 mit dem Nullleiter N verbunden ist, den Widerstand 4 sowie das Auslösemodul 3, welches von der Steuereinheit 5 über die Signalleitung 6 angesteuert wird. Da der Nullleiter N und der PE-Leiter PE auf dem gleichen elektrischen Potential liegen, sieht die Testeinrichtung darüber hinaus einen Transformator 11 als eine Spannungsbereitstellungseinheit vor. Der Transformator 11 ist sekundärseitig in die Strom-Bypass-Leitung 2 eingebunden. Er wird primärseitig gespeist zur Bereitstellung einer Spannungsdifferenz zwischen den beiden über die Strom-Bypass-Leitung 2 verbundenen Leitern N, PE. Über die von dem Transformator 11 bereitgestellte Spannungsdifferenz und die Größe des Widerstands 4 ist der Bypass-Strom betragsmäßig bestimmt.

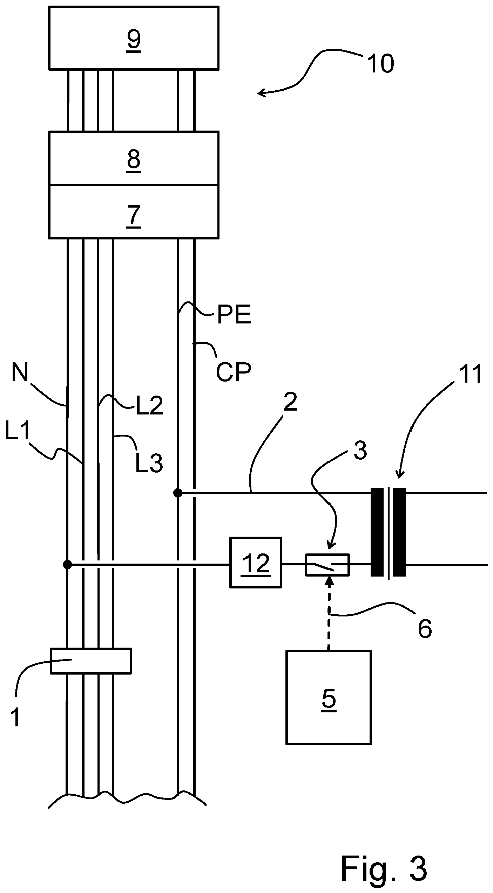

Einen ähnlichen Aufbau zeigt eine dritte Ausführungsform der Versorgungsstation nach der Figur 3. Hier ist statt des Widerstands 4 eine Konstantstromquelle 12 als Stromvorgabemodul vorgesehen. Über die Konstantstromquelle 12 wird der Bypass-Strom in der Strom-Bypass-Leitung 2 stets auf einem bekannten, konstanten Niveau oberhalb des Mindestauslösedifferenzstroms des Fehlerstromschutzschaltelements 1 vorgesehen.

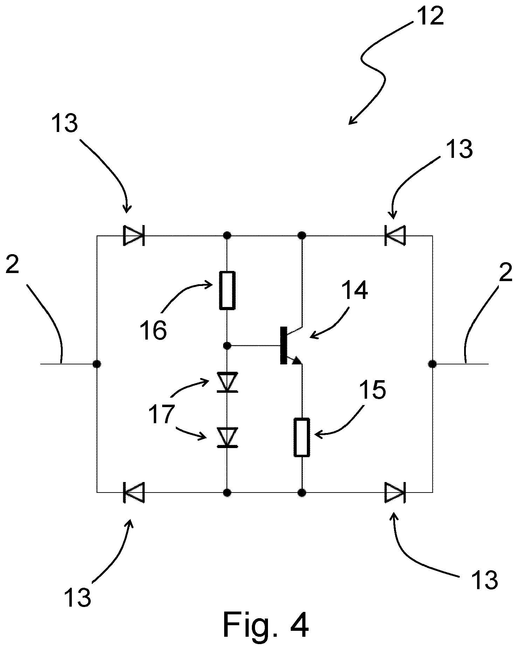

Die Konstantstromquelle 12 kann in üblicher, dem Fachmann bekannter Weise realisiert werden. Ein Beispiel zeigt Figur 4. Demzufolge ist die in die Strom-Bypass-Leitung 2 integrierte Konstantstromquelle 12 als eine Vollbrückenschaltung mit vier Vollbrückendioden 13 realisiert. Zwischen je zwei Vollbrückendioden 13 ist ein erster Brückenzweig mit einem Transistor 14 vorgesehen, an dessen Ausgang (Emitter) ein stets gleiches Spannungsniveau bereitgestellt wird. Über einen dem Emitter zugeordneten Widerstand 15 definiert sich insofern der konstante Bypass-Strom.

Parallel zu dem Transistor 14 ist ein zweiter Brückenzweig mit einem Widerstand 16 und zwei zueinander in Reihe geschalteten Dioden 17 vorgesehen. Zwischen dem Widerstand 16 und den Dioden 17 ist die Basis des Transistors 14 verbunden.

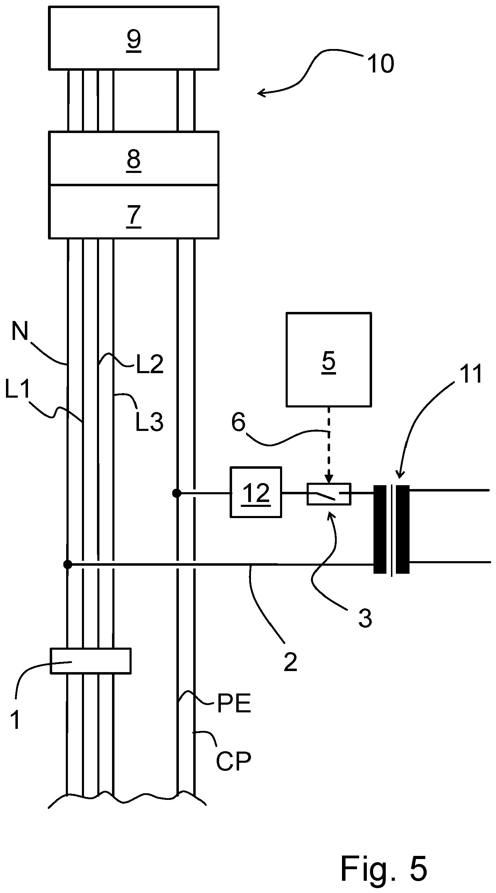

Figur 5 zeigt eine vierte Ausführungsform der Versorgungsstation. Während bei der dritten Ausführungsform die Konstantstromquelle 12 und das Auslösemodul 3 in dem Teil der Strom-Bypass-Leitung 2 vorgesehen sind, wird nunmehr über den PE-Leiter geschaltet. Das Auslösemodul 3 sowie die Konstantstromquelle 12 sind hierzu zwischen dem PE-Leiter PE und der Sekundärseite des Transformators 11 angeordnet.

Gleiche Bauteile und Bauteilfunktionen sind durch gleiche Bezugszeichen gekennzeichnet.

## Patentansprüche

1. Betriebsverfahren für eine Versorgungsstation mit einer Steuereinheit (5) zum Durchführen eines Ladevorgangs und/oder eines Entladevorgangs für eine Fahrzeugbatterie (9), mit einem Anschlussmittel (7) zum leitenden Verbinden eines elektrisch betreibbaren Fahrzeugs mit der Versorgungsstation, mit Übertragungsmitteln, wobei die Übertragungsmittel angeordnet und ausgebildet sind zur Realisierung eines uni- oder bidirektionalen Energieflusses zwischen einem Versorgungsnetz und dem Anschlussmittel (7) und wobei die Übertragungsmittel einen Nullleiter (N), einen PE-Leiter (PE) und wenigstens einen Phasenleiter (L1, L2, L3) umfassen, mit einem den Übertragungsmitteln zugeordneten Betriebsschaltmittel zum wahlweisen Herstellen und Unterbrechen der elektrisch leitenden Verbindung zwischen dem Anschlussmittel (7) und dem Versorgungsnetz, mit einem Fehlerstromschutzschaltelement (1), welches dem wenigstens einen Phasenleiter (L1, L2, L3) sowie dem Nullleiter (N) zugeordnet ist zur Erkennung eines Differenzstrom-Fehlerfalls und zur Unterbrechung der elektrisch leitenden Verbindung zwischen dem Anschlussmittel (7) und dem Versorgungsnetz im Differenzstrom-Fehlerfall, und mit einer Testeinrichtung für das Fehlerstromschutzschaltelement (1) umfassend eine Strom-Bypass-Leitung (2), welche unter Umgehung des Fehlerstromschutzschaltelements (1) von dem Nullleiter (N) einerseits zu einem ausgewählten Phasenleiter (L3) oder dem PE-Leiter (PE) andererseits geführt ist, umfassend ein von der Steuereinheit (5) ansteuerbares Auslösemodul (3) zum wahlweisen Öffnen oder Schließen der Strom-Bypass-Leitung (2) und umfassend ein in der Strom-Bypass-Leitung (2) angeordnetes Stromvorgabemodul, wobei zunächst
- das Auslösemodul (3) in einer Unterbrechungsschaltstellung vorgesehen wird, in der die Strom-Bypass-Leitung (2) geöffnet ist,
- das Fehlerstromschutzschaltelement (1) in einer Überwachungsschaltstellung vorgesehen wird, in der der Differenzstrom-Fehlerfall erkannt wird, und
- eine Zeitintervall-Ermittlung gestartet wird,
und wobei dann zeitgesteuert nach Ablauf des Zeitintervalls eine Funktionsselbsttestroutine für das Fehlerstromschutzschaltelement (1) durchgeführt wird mit den folgenden Verfahrensschritten:
- ein Auslösesignal wird von der Steuereinheit (5) an das Auslösemodul (3) gesendet,
- das Auslösemodul (3) empfängt das Auslösesignal und wird von der Unterbrechungsschaltstellung in eine Verbindungsschaltstellung verbracht, in der die Strom-Bypass-Leitung (2) den Nullleiter (N) einerseits mit dem ausgewählten Phasenleiter (L3) oder dem PE-Leiter (PE) anderseits elektrisch leitend verbindet und über den Strom-Bypass-Leiter (2) ein Bypass-Strom fließt, der betragsmäßig von dem Stromvorgabemodul bestimmt ist und der oberhalb eines Mindestauslösedifferenzstroms des Fehlerstromschutzschaltelements (1) liegt,
- dann wird eine Schaltstellung des Fehlerstromschutzschaltelements (1) bestimmt und ein Ergebnis der Funktionsselbsttestroutine dokumentiert, wobei zur Dokumentation eine Ausführungszeitinformation einerseits und die Schaltstellung des Fehlerstromschutzschaltelements (1) oder ein hierzu korrespondierender Zustandswert anderseits in einem Datenspeicher gespeichert werden und wobei die Versorgungsstation außer Betrieb genommen wird, sofern das Fehlerstromschutzschaltelement (1) nicht auslöst und in der Überwachungsschaltstellung verbleibt.

2. Betriebsverfahren nach Anspruch 1, **dadurch gekennzeichnet, dass** der Datenspeicher mit der Dokumentation des Ergebnisses der Funktionsselbsttestroutine über eine Datenschnittstelle von extern ausgelesen wird.

3. Betriebsverfahren nach Anspruch 1 oder 2, **dadurch gekennzeichnet, dass** eine neue Zeitintervall-Ermittlung unmittelbar nach der Durchführung der Funktionsselbsttestroutine und/oder nach dem Zurücksetzen des Fehlerstromschutzschaltelements (1) in die Überwachungsschaltstellung gestartet wird.

4. Betriebsverfahren nach einem der Ansprüche 1 bis 3, **dadurch gekennzeichnet, dass** bei einem Neustart und/oder einem Reset der Versorgungsstation die gespeicherten Ergebnisse der letzten Funktionsselbsttestroutine in einem der Versorgungsstation zugeordneten Display angezeigt werden und/oder dass ereignisgesteuert bei jedem Neustart und/oder Reset der Versorgungsstation die Funktionsselbsttestroutine durchgeführt wird, wobei bevorzugt vor dem Versenden des Auslösesignals das Auslösemodul (3) in der Unterbrechungsschaltstellung und das Fehlerstromschutzschaltelement (1) in der Überwachungsschaltstellung vorgesehen werden.

5. Betriebsverfahren nach einem der Ansprüche 1 bis 4, **dadurch gekennzeichnet, dass** der Bypass-Strom betragsmäßig bestimmt wird durch einen Widerstand (4) und/oder durch eine Konstantstromquelle (12) des Stromvorgabemoduls.

6. Betriebsverfahren nach einem der Ansprüche 1 bis 5, **dadurch gekennzeichnet, dass** der Bypass-Strom bei unter 200 mA und bevorzugt im Bereich von 20 mA bis 50 mA liegt.

7. Betriebsverfahren nach einem der Ansprüche 1 bis 6, **dadurch gekennzeichnet, dass** das Auslösesignal nach dem Ablauf des Zeitintervalls erst dann an das Auslösemodul (3) gesendet wird, wenn ein im Moment des Ablaufs des Zeitintervalls laufender Lade- oder Entladevorgang beendet ist, und/oder dass das Auslösesignal nicht an das Auslösemodul (3) gesendet wird, solange ein laufender Lade- oder Entladevorgang läuft.

8. Betriebsverfahren nach einem der Ansprüche 1 bis 7, **dadurch gekennzeichnet, dass** als Teil der Testeinrichtung eine Spannungsbereitstellungseinheit vorgesehen ist und dass jedenfalls beim Ausführen der Funktionsselbsttestroutine von der Spannungsbereitstellungseinheit eine Spannung zwischen dem Nullleiter (N) und dem PE-Leiter (PE) bereitgestellt wird.

9. Betriebsverfahren nach einem der Ansprüche 1 bis 8, **dadurch gekennzeichnet, dass** als Ausführungszeitinformation ein kalendarisch bestimmter Ausführungszeitpunkt der Funktionsselbsttestroutine oder eine Betriebszeitdauer seit der letzten Ausführung der Funktionsselbsttestroutine gespeichert wird.

10. Betriebsverfahren nach einem der Ansprüche 1 bis 9, **dadurch gekennzeichnet, dass** das Zeitintervall durch einen Vorgabewert definiert wird, wobei der Vorgabewert gespeichert wird und veränderbar ist.

11. Betriebsverfahren nach einem der Ansprüche 1 bis 10, **dadurch gekennzeichnet, dass** das Zeitintervall kalendarisch und/oder über die Betriebszeitdauer bestimmt wird.

12. Betriebsverfahren nach einem der Ansprüche 1 bis 11, **dadurch gekennzeichnet, dass** der Steuereinheit (5) eine Übertragungseinheit zugeordnet ist und dass mittels der Übertragungseinheit die Ausführungszeitinformation und/oder die Schaltstellung des Fehlerstromschutzschaltelements (1) und/oder der hierzu korrespondierende Zustandswert an eine externe Empfangseinheit übertragen werden.

13. Betriebsverfahren nach einem der Ansprüche 1 bis 12, **dadurch gekennzeichnet, dass** das Fehlerstromschutzschaltelement (1) nach einer erfolgreichen Durchführung der Funktionsselbsttestroutine manuell aus einer Fehlerschaltstellung, in der die elektrisch leitende Verbindung zwischen dem Anschlussmittel (7) und dem Versorgungsnetz unterbrochen ist, in die Überwachungsschaltstellung zurückverbracht wird.

14. Versorgungsstation für ein elektrisch betreibbares Fahrzeug umfassend
- eine Steuereinheit (5) zum Durchführen eines Ladevorgangs und/oder eines Entladevorgangs für eine Fahrzeugbatterie (9),
- ein Anschlussmittel (7) zum leitenden Verbinden des Fahrzeugs mit der Versorgungsstation,
- Übertragungsmittel, wobei die Übertragungsmittel angeordnet und ausgebildet sind zur Realisierung eines uni- oder bidirektionalen Energieflusses zwischen einem Versorgungsnetz und dem Anschlussmittel (7) und wobei die Übertragungsmittel einen Nullleiter (N), einen PE-Leiter (PE) und wenigstens einen Phasenleiter (L1, L2, L3) umfassen,
- ein den Übertragungsmitteln zugeordnetes Betriebsschaltmittel zum wahlweisen Herstellen und Unterbrechen der elektrisch leitenden Verbindung zwischen dem Anschlussmittel (7) und dem Versorgungsnetz,
- ein Fehlerstromschutzschaltelement (1), welches dem wenigstens einen Phasenleiter (L1, L2, L3) sowie dem Nullleiter (N) zugeordnet ist zur Erkennung eines Differenzstrom-Fehlerfalls und zur Unterbrechung der elektrisch leitenden Verbindung zwischen dem Anschlussmittel (7) und dem Versorgungsnetz im Differenzstrom-Fehlerfall, und
- eine Testeinrichtung für das Fehlerstromschutzschaltelement (1) mit einer Strom-Bypass-Leitung (2), welche unter Umgehung des Fehlerstromschutzschaltelements (1) von dem Nullleiter (N) einerseits zu einem ausgewählten Phasenleiter (L3) oder dem PE-Leiter (PE) andererseits geführt ist, mit einem von der Steuereinheit (5) ansteuerbaren Auslösemodul (3) zum wahlweisen Öffnen oder Schließen der Strom-Bypass-Leitung (2) und mit einem in der Strom-Bypass-Leitung (2) angeordneten Stromvorgabemodul,
wobei die Versorgungsstation eingerichtet ist zur Durchführung eines Betriebsverfahrens nach einem der Ansprüche 1 bis 13.

15. Versorgungsstation nach Anspruch 14, **dadurch gekennzeichnet, dass** die Testeinrichtung eine Spannungsbereitstellungseinheit vorsieht, wobei mittels der Spannungsbereitstellungseinheit eine Spannung zwischen dem Nullleiter (N) und dem PE-Leiter (PE) bereitgestellt ist.

16. Versorgungsstation nach Anspruch 14 oder 15, **dadurch gekennzeichnet, dass** ein Transformator (11) als Spannungsbereitstellungseinheit vorgesehen ist und/oder dass das Stromvorgabemodul einen Widerstand (4) oder eine Konstantstromquelle (12) vorsieht zur betragsmäßigen Bestimmung des Bypass-Stroms.
